# EUROPEAN PATENT SPECIFICATION

(11) **EP 2 076 916 B1**
(45) Date of publication and mention of the grant of the patent: **10.12.2014**
(21) Application number: 07819370.3
(22) Date of filing: 26.10.2007
(51) Int. Cl.: H01J 37/32, H01J 37/34

(54) **DUAL MAGNETRON SPUTTERING POWER SUPPLY AND MAGNETRON SPUTTERING APPARATUS**
ZWEIFACH-MAGNETRON-SPUTTER-STROMVERSORGUNG UND MAGNETRON-SPUTTERVORRICHTUNG
ALIMENTATION DE BOMBARDEMENT CATHODIQUE À DOUBLE MAGNÉTRON ET APPAREIL DE BOMBARDEMENT CATHODIQUE À MAGNÉTRON

(30) Priority: 26.10.2006 EP 06022396
(43) Date of publication of application: 08.07.2009
(73) Proprietor: IHI Hauzer Techno Coating B.V., 5928 LL Venlo (NL)
(72) Inventor: TIETEMA, Roel, 5926 SK Venlo (NL); PAPA, Frank, 5913 VK Venlo (NL); SESINK, Geert, 5591 KA Heeze (NL); THOMASITA, René, 5915 VV Venlo (NL)
(74) Representative: Manitz, Finsterwald & Partner GbR
(86) International application number: PCT/EP2007/009326
(87) International publication number: WO 2008/049634

(56) References cited:
- WO-A-00/28104
- US-A- 5 169 509
- US-A1- 2005 205 413
- US-B1- 6 511 584

## Description

The present invention relates to a dual magnetron sputtering power supply and to a magnetron sputtering apparatus in combination with or having such a dual magnetron sputtering power supply.

When using magnetron sputtering apparatus problems can arise with so-called target poisoning. For example, with an aluminum cathode and using O₂ as the reactive gas, the cathode is initially clean aluminum. In the presence of reactive O₂ a layer of aluminum oxide forms on the target thus poisoning it. A layer of aluminum oxide also forms on the anode, and this insulating layer means the anode starts to "disappear" so far as the cathode is concerned. By changing the polarity of the power supply to the cathode, which inherently occurs in a dual magnetron sputtering apparatus because an alternating power source is connected between the two cathodes, the oxide film on the one cathode, which was previously an anode, is initially more negative because of the electrons which accumulated on the insulating layer and is more strongly bombarded with ions thus cleaning it, i.e. the partial insulating coating on the cathodes, broken down again by the inert gas ions present in the chamber. The coating of articles placed in the vacuum chamber effectively takes place alternately from the first and second cathodes which are operated anti-phase. When one cathode is operating as a cathode, the other cathode is operating as an anode. The voltage at the cathodes varies with the degree of poisoning of the target, i.e. of the cathode surface.

Dual magnetron sputtering systems are, for example, used in glass coating applications and have two cathodes arranged alongside one another, with a supply of oxygen generally being located between them. The state of the art for a dual magnetron sputtering configuration (as it seems to be done in glass coaters) appears to use a voltage feedback signal to control the reactive gas flow to one of the cathodes in order to keep that cathode at a stable working point. However, it seems to be problematic to achieve such a control over a range of working conditions because of hysteresis in the relationship between the voltage feedback signal and the degree of poisoning of the cathode which is dependent on the reactive gas flow, on the amount of reactive gas which can react with the cathode and the cleaning of the cathode which takes place in alternate half cycles.

The object underlying the present invention is to provide a dual magnetron sputtering power supply and magnetic sputtering apparatus in combination with or having such a dual magnetron sputtering power supply which is able to operate in a stable manner over any desired length of a sputter coating phase, which ensures that the desired balanced operation of sputtering from each of the two cathodes is achieved and leads to a high quality sputtered coating with relatively inexpensive means. Furthermore, it is an object of the present invention to provide a dual magnetron sputtering power supply, and a magnetron sputtering apparatus in combination with or having such a dual magnetron sputtering power supply, which is able to cope with voltage variations at the cathodes arising from the movement of individual articles to be coated and elements of the workpiece support for the articles (the workpiece table) through the space in front of the cathodes. It should also be able to take account of the fact that the vacuum pump used to maintain the vacuum chamber at the required low pressure level inevitably tends to remove more reactive gas from one cathode than the other cathode for symmetry reasons.

In order to satisfy this object there is provided, in accordance with the present invention, a dual magnetron sputtering power supply according to claim 1.

By providing a dual magnetron sputtering power supply of this kind it is possible to control the flow of the reactive gas to each of the cathodes, by controlling the respective flow control valves for the supply of reactive gas to each said cathode in such a way that balanced operation of a magnetron sputtering apparatus is achieved and thus a stable working point. Because each cathode becomes slightly poisoned during one half cycle of the AC power supply and is then partially cleaned again during the next half cycle, it is desirable to achieve an average degree of poisoning of each cathode which remains constant over many cycles of an AC power supply and indeed preferably for the degree of poisoning of each cathode to be the same, and indeed taking automatic account of the possible asymmetry of the removal of reactive gases from the vicinity of each of the cathodes by the vacuum pump associated with the apparatus. The above recited system makes it possible to achieve this end.

The invention is defined by the claims.

Preferred embodiments of the invention are set forth in the subordinate claims. It is particularly expeditious to measure the voltage prevailing at each of the cathodes with reference to earth or ground because this provides voltage feedback signals related to a common reference point (ground).

According to the invention, the control circuit comprises a respective regulator or controller for each cathode having as inputs the feedback signals from the cathodes and respective set point signals and producing as outputs a respective partial pressure set point signal, wherein a respective probe respectively associated with each cathode generates an actual pressure signal of the reactive gas, wherein the partial pressure set point signals and the respective actual pressure signals are applied to respective inputs of further regulators or controllers, the respective output signals of which serve to generate actuation signals for actuating the flow control valves supplying reactive gas to the respectively associated cathodes. That is to say there are nested voltage and partial pressure control loops which result in a high quality control of the dual magnetron sputtering apparatus so that very stable operation can be maintained at each of the two cathodes with the desired composition of the sputtered coating being obtained.

The present invention will now be explained in more detail with reference to the embodiments and to the accompanying drawings in which are shown:
- Fig. 1: a first practical example of a dual magnetron sputtering power supply shown in schematic form,
- Figs. 2A to 2C: diagrams to explain the voltages present at two cathodes (cathode 1, Fig. 2B and cathode 4, Fig. 2C) fed in a magnetron sputtering apparatus by an AC voltage in accordance with Fig. 2A which is applied between them,
- Fig. 3: a schematic diagram to illustrate the layout of a magnetron sputtering apparatus and to further explain the asymmetry of the removal of reactive gas from the vacuum chamber by the vacuum pump, and
- Fig. 4: a preferred embodiment of the dual magnetron sputtering power supply in accordance with the present invention.

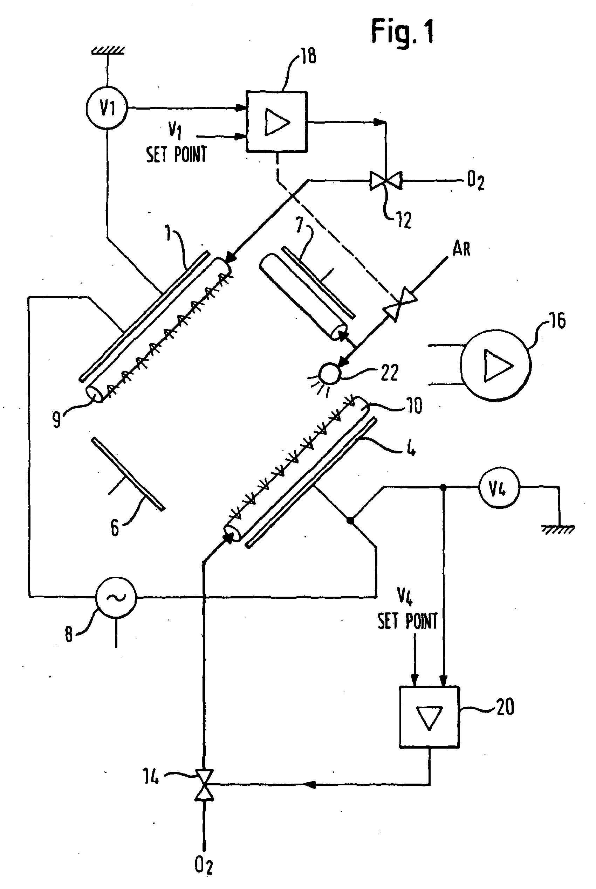

Turning now to Fig. 1, the attached drawing shows a dual magnetron sputtering power supply (DMS) in accordance with an example. The dual magnetron sputtering power supply is connected to first and second cathodes 1 and 4. The cathodes 1 and 4 are located with other cathodes 6 and 7 and optionally with further arc cathodes or magnetron cathodes (not shown) in a vacuum chamber (also not shown) and can be operated from an AC power supply 8 which usually is connected as shown in Fig. 1 so that alternating operation of the two generally opposed cathodes is achieved. Each of the first and second cathodes 1 and 4 is equipped with a respective gas frame 9, 10 for the supply of reactive gas at an inlet near the respective cathode. The cathodes 1 and 4 are connected to the DMS (Dual Magnetron Sputtering Power Supply) .

The cathodes may be, but do not necessarily need to be opposed to each other. State of the art for a DMS configuration (as it seems to be done in glass coaters) is that a voltage feedback signal controls the reactive gas flow (here: O₂ flow) to cathode 1, in order to keep the cathode at a stable working point (see literature of Bill Sproul on IRESS). The O₂ flow to the second cathode 4 is controlled in the prior art by an Optical Emission Controller.

US 5169509 discloses a dual magnetron sputtering apparatus in which the flow of reactive gas is regulated by controlling the voltage.

In contrast, in accordance with the present disclosure, a feedback signal ("V1-signal") from first cathode 1 voltage (or from the DMS power supply) is used for control of a first O₂ inlet valve 12 at the first cathode 1, whereas control of a second O₂ inlet valve at the second cathode 4 is governed by the feedback signal ("V4-signal") of the second cathode 4 voltage. These are separate transmitters of voltage, measuring AC apparent voltage, AC rectified voltage or DC voltage. The elements shown in the drawing by symbols have their usual meaning. Thus, the triangle in a circle 16 represents the vacuum pump for producing the required operating vacuum in the chamber and the triangle in a square symbol signifies a feedback controlled regulator 18, 20 respectively.

In both cases the O₂-flow is increased until the respective cathode voltage reaches the set point value V₁ SET POINT and V₄ SET POINT respectively corresponding to the requirement of the control system. This set point value is generally chosen to be a DC voltage but it could also be a profiled, time dependent voltage. For O₂ this value is lower than the voltage in metallic (non-reactive) mode, at least when the cathodes are made of A1 for forming, e.g., an Al₂O₃ coating. For other gas/metal combinations this might be a higher value.

The argon (Ar) flow for sputtering (non-reactive sputter gas) is supplied at a different place 22 than the O₂ inlet (in general this is the state of the art), but it could also be supplied near the cathode, e.g. at 22', or combined near the cathode. It can also be supplied at one of the other cathodes or centrally or at any other appropriate place in or adjacent to the vacuum chamber or system.

The control system is preferably realized with fast response MFC's (mass flow controllers), i.e. 18, 20, for reactive sputtering of oxygen or other difficult to sputter materials with a fairly big voltage difference between the metallic mode and the fully poisoned reactive mode. The problem of target poisoning is one of the prime reasons for using a dual mode magnetron sputtering system. For example, with an Al cathode and using O₂ as the reactive gas the cathode is initially clean aluminum. In the presence of reactive O₂ a layer of aluminum oxide forms on the target thus poisoning it. By changing the polarity of the power supplied to the cathode, inherent in DMS, the oxide film is broken down again by the inert gas ions in the chamber. Thus the coating of articles placed in the vacuum chamber effectively takes place alternately from the first and second cathodes which are operated antiphase. The voltage at the cathodes varies with the degree of poisoning of the target (cathode surface).

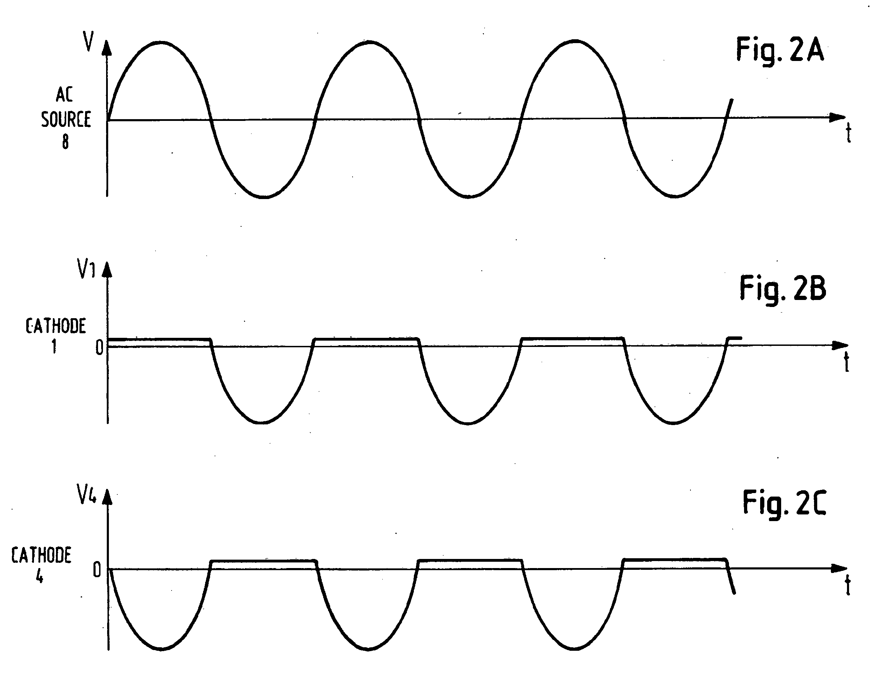

Turning now to Figs. 2A to 2C, an explanation can be given of how the sinusoidal wave form generated by the AC power source 8 as shown in Fig. 2A relates to the voltages at the two cathodes 1 and 4.

Because the two cathodes 1 and 4 are connected to respective output terminals of the AC source and because the conditions inside the vacuum chamber means that this acts as a rectifier diode, the voltage at the cathodes 1 and 4 in each case corresponds to a negative half wave of the sinusoidal supply, with the two half waves being shifted relative to one another by 180° as shown in Figs. 2B and 2C. Because of the rectifying action of the magnetron sputtering apparatus, which operates in both directions, i.e. the polarity of the effective anode is reversed each half cycle, the voltage at the cathodes during the positive half phases is only slightly above zero and the cathode acts during this part of the cycle as an anode. Thus, during the negative half waves, the cathodes 1 and 4 act as cathodes, in the periods in between they act as anodes with a small anode voltage. When they are acting as cathodes, during the negative half cycles, reactive sputtering takes place from the respective cathode and the cathode surface is cleaned. During the period the respective cathodes act as an anode, i.e. each alternate half cycle, sputtered material accumulates on them, i.e. insulating material and this accumulated material is subsequently removed again during the next negative half cycle when the respective cathode is acting as a sputtering cathode. Thus, although the cathodes become contaminated, they are cleaned again during each half cycle in which they are acting as sputtering cathodes the desired reactive sputtering takes place, with it being possible to keep the average degree of poisoning at each cathode 1, 4 constant over a long period of time.

It should be noted that the peak negative amplitude of the voltage present at the cathodes 1 and 4 as shown in Figs. 2B and 2C is generally desirably the same at each cathode, but is less than the open circuit output of the AC source 8 because of the average degree of target poisoning.

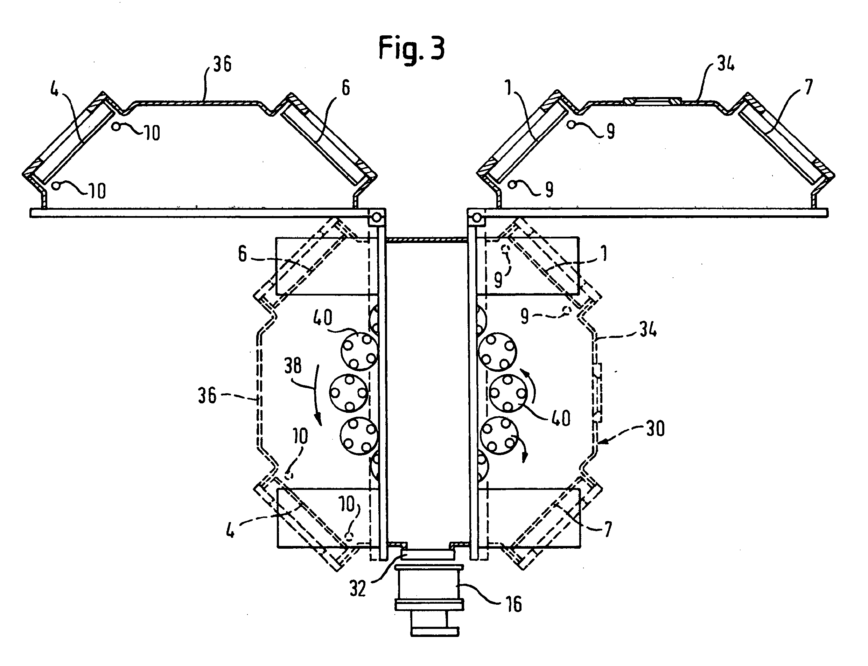

Turning now to Fig. 3 there can be seen a schematic drawing of a magnetron sputtering apparatus having a chamber 30 of generally octagonal shape in the traditional form used by Hauzer Techno Coating BV. The chamber has a central portion 32 and two large hinged doors 34, 36 which each include two elongate, generally rectangular cathodes 1, 7 and 4, 6, which can thus be easily accessed for maintenance and exchange. The long sides of the rectangular cathodes are perpendicular to the plane of the drawing. Associated with each cathode 1, 7, 4, 6 is, in the usual way, a system of magnets (permanent magnets and/or magnetic coils) which generate the magnetic field necessary for magnetron operation. These magnet systems are not shown in any of the drawings of this application, and indeed this is not necessary because they are well understood by a person skilled in the art.

The pivotally mounted doors 34, 36 can be pivoted into the position shown in broken lines to close the chamber in use. The chamber typically has a generally octagonal base and octagonal cover which seal the chamber so that a vacuum can be generated therein by the vacuum pump 16. Within the chamber there is usually a rotary table 28 which carries workpieces either directly or on further smaller rotary tables 40 which rotate about their own axes as well as rotating with the table 38 about the central vertical axis of the chamber.

It can be seen from Fig. 3 that the cathode 4 is closer to the vacuum pump 16 than the cathode 1, i.e. the generally opposed cathodes 1, 4 are asymmetrically arranged with respect to the vacuum pump 16 and this means that the vacuum pump 16 will tend to extract more reactive gas from the vicinity of the cathode 4 than from the vicinity of the cathode 1 and this has to be compensated by increasing the supply of reactive gas via a respective gas frame 10 associated with the cathode 4 relative to the supply of reactive gas supplied via the gas frame 9 associated with the cathode 1.

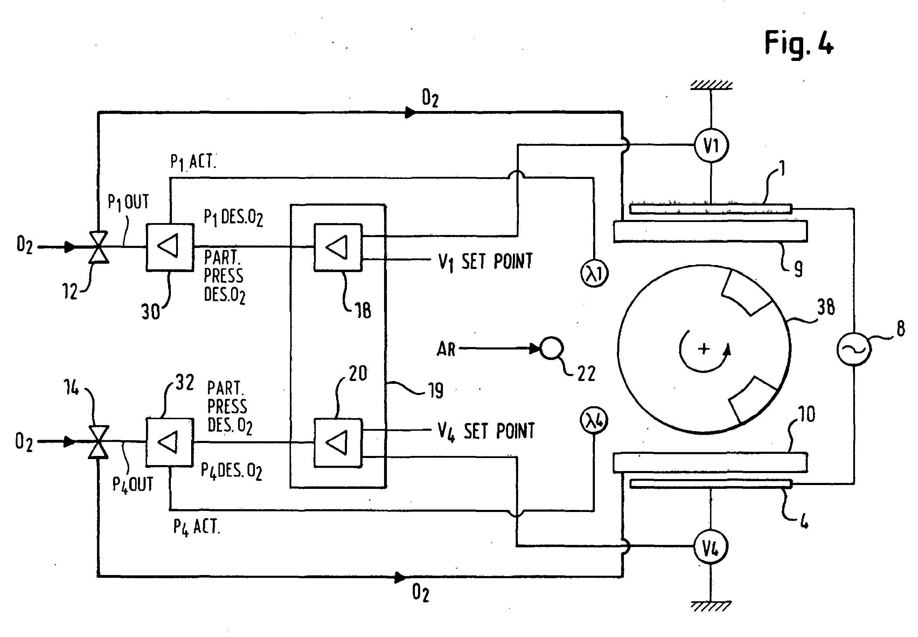

Turning now to Fig. 4, a preferred embodiment of the dual magnetron sputtering power supply in accordance with the present invention will now be described. In this Figure, some reference numerals are common to the reference numerals used in Fig. 1 and it will be understood that these reference numerals refer to the same items as in Fig. 1 and that the same description applies unless something is specifically stated to the contrary. Again in Fig. 4 the vacuum chamber is not shown for the sake of simplicity.

Again, the magnet systems associated with the cathodes 1 and 4 are not shown and also relative to Fig. 1 the further cathodes such as 6 and 7 have been omitted. The workpiece table 38, i.e. the table which carries the workpieces, is schematically illustrated between the opposed cathodes 1 and 4 as are the gas frames 9 and 10 associated with the respective cathodes. It should be noted that the gas frames do not necessarily have to extend around all four sides of the rectangular cathodes but typically extend along the two longitudinal sides of the elongate rectangular cathodes as shown by the drawings of Figs. 1, 3 and 4. The idea is to obtain a uniform gas distribution in front of the cathodes.

Fig. 4 shows, in distinction to Fig. 1, first and second lambda sensors, λ₁ and λ₄, which are arranged in the proximity of the cathodes 1 and 4 and of the gas frames 9 and 10 and which serve to measure the partial pressure of the reactive gas, in this case oxygen. If the reactive gas is a different gas, for example nitrogen, then obviously other probes have to be used which are sensitive to the concentration of the reactive gas being used.

In the embodiment of Fig. 4, as in the example of Fig. 1, the voltage of each cathode relative to ground is measured and respective voltage signals V1 and V4, which comprise the actual voltage signals, are supplied to respective regulators 18 and 20 which can, for example, be completely separate regulators or can be integrated into a common control system as indicated by the block in Fig. 4. This can, for example, be a sps controller or regulator system 19 as well known per se. Each of the two regulators or controllers 18 and 20 receives a set point signal V_{1SETPOINT}, V_{4SETPOINT} for the respective voltages V1 and V4, which can either be fixed voltages or can have a specific voltage profile desired for a particular operation. The controllers or regulators 18 thus each compare the actual measured voltage V1 and V4 with the respective set point voltage V_{1SETPOINT} and V_{4SETPOINT} respectively and produce an output signal which represents a desired partial pressure signal for the reactive gas, in this case O₂, in the vicinity of the respective cathode 1 or 4. The values of V_{1SETPOINT} and V_{4SETPOINT} are generally the same as each other. The signals from the two lambda sensors, λ₁ and λ₄, provide a signal proportional to the actual partial pressure P_{1ACT} and P_{4ACT} respectively present in the vicinity of the cathodes 1 and 4. The boxes labeled 30 and 32 represent further regulators or controllers which then compare the desired partial pressure signals abbreviated P_{1DES.O2} and P_{4DES.O2}, with the actual pressure signals P_{1ACT} and P_{4ACT} and produce output signals P_{1OUT} and P_{2OUT} which control the mass flow control flows 12 and 14 used to control the flow of the reactive gas, in this example O₂, to the respective gas frames 9 and 10. The input lines to the gas flow controllers 12 and 14 can come from a common source and they are simply schematically shown as if they come from different sources in Fig. 4.

In a dual mode magnetron sputtering system having workpieces on a movable workpiece table 38 there is a significant tendency for electrons in the vicinity of the cathodes 1 and 4 to be affected by gaps which appear on rotation of the workpiece table in such a way that they may tend to move to the other respective cathode when acting as an anode and thus result in fluctuation of the voltage signals V₁ and V₄. The regulators or controllers 18, 20 are selected to be relatively slow regulators so that they tend to smooth out voltage fluctuations and maintain the voltages V₁ and V₄ measured at the respective cathodes 1 and 4 within preselected bandwidths. Thus, fluctuations of the voltages V₁ and V₄ do not lead to instabilities in operation.

As stated earlier, the output signals of the regulators or controller 18, 20 are used as desired partial pressure signals (partial pressure set point signals) for the partial pressures of the reactive gas present in the vicinity of the cathodes 1 and 4. The action of the output signals P_{1OUT} and P_{4OUT} of the further regulators 30 and 32 on the mass flow controllers 12 or 14 thus tries to correct the supply of reactive gas to the respective cathodes 1 and 4 so that the actual pressure values P_{1ACT} and P_{4ACT} correspond as closely as possible to the partial pressure desired signals P_{1DES.O2} and P_{4DES.O2}. The respective partial pressures set in this way in turn vary the voltage feedback signals V₁ and V₄ and thus permit correction of the conditions prevailing at the cathodes 1 and 4 so that these are operated at or close to the desired set point values V_{1SETPOINT} and V_{4SETPOINT} respectively.

Although the further regulators 30 and 32 are described as hard regulators in the sense that they react quickly to changes of the desired partial pressures P_{1DES} and P_{4DES}, it is believed that these could also be realized as soft regulators without significant disadvantage.

It should be noted that when using lambda sensors the character of the feedback signal means that a decrease of the set point value physically relates to an increase of the partial pressure (for example in mbar).

So the actual pressures are sensed as samples and after each sampling interval a change of a set point can occur. The precise layout of the controls can include multiplication of signals with predefined values to improve the control response and to ensure that the system operates within the preset bandwidths.

It should also be noted that it is possible to build in alarms into the system such that if operating parameters move outside of the preset bandwidths an alarm signal is generated and optionally some other step is automatically taken to overcome the difficulty, for example shutdown of the apparatus until the reason for the alarm has been diagnosed and remedied.

## Claims

1. A dual magnetron sputtering power supply for use with a magnetron sputtering apparatus having at least first and second sputtering cathodes (1, 4) for operation in the dual magnetron sputtering mode, said dual magnetron sputtering power supply comprising:
- an AC power supply (8) connectable to the first and second sputtering cathodes (1, 4);
- first and second flow control valves (12, 14) each associated with a respective one of said first and second cathodes (1,4) and each adapted to control, in use, a flow of reactive gas to the respectively associated cathode;
- a means (9, 10) arranged to supply, in use, a flow of reactive gas to each of said first and second cathodes (1, 4) via said first and second flow control valves (12, 14);
- for each of said first and second cathodes, a means arranged to derive, in use, a voltage feedback signal (V₁, V₄) relating to the voltage prevailing at that cathode (1, 4);
- a control circuit (18, 20) arranged to control, in use, the flow of reactive gas to the respectively associated cathode (1, 4) by controlling the respective flow control valve (12, 14) and adapted to adjust, in use, the respective flow control valve (12, 14) to obtain the voltage feedback signal (V₁ , V₄) from the respective cathode (1, 4) corresponding to a set point value (V_{1SETPOINT}, V_{4SETPOINT}) set for that cathode;
**characterised in that**
said control circuit (18, 20) comprises a respective regulator for each cathode arranged to have as inputs the voltage feedback signals (V₁, V₄) from the cathodes (1, 4) and respective set point signals (V_{1SETPOINT}, V_{4SETPOINT}), and arranged to produce as outputs a respective partial pressure set point signal (P_{1DES}, P_{4DES});
the dual magnetron sputtering power supply further comprises a respective probe (λ₁, λ₄) respectively associated with each cathode (1, 4) and arranged to generate, in use, an actual pressure signal of the reactive gas (P_{1ACT}, P_{4ACT}); and
further regulators (30, 32) arranged such that, in use, the partial pressure set point signals (P_{1DES}, P_{4DES}) and the respective actual pressure signals (P_{1ACT}, P_{4ACT}) are applied to respective inputs of said further regulators (30, 32), the respective output signals of which being arranged to generate, in use, actuation signals (P_{1OUT} and P_{4OUT}) actuating the flow control valves (12, 14) supplying reactive gas to the respectively associated cathodes (1, 4).

2. A dual magnetron sputtering power supply in accordance with claim 1, wherein the reactive gas is supplied via the respective flow control valve (12, 14) to each of said first and second cathodes (1, 4) via a gas frame respectively associated with that cathode(1, 4).

3. A dual magnetron sputtering power supply in accordance with any one of the preceding claims, wherein the voltage feedback signal (V₁, V₄) for each of said first and second cathodes (1, 4) is one of a voltage measuring device for measuring the apparent AC voltage applied to each respective cathode, or for measuring a rectified AC voltage or for measuring a related DC voltage or for tapping the output voltage supplied by the power supply (8) to the respective cathode (1, 4).

4. A dual magnetron sputtering power supply in accordance with any one of the preceding claims, wherein the said first and second cathodes (1, 4) are opposed cathodes of the magnetron sputtering apparatus.

5. A dual magnetron sputtering power supply in accordance with any one of the preceding claims wherein the cathode material of each of said first and second cathodes (1, 4) is selected from the group including metals such as aluminum or titanium, semiconductors such as silicon and mixtures of any of the foregoing and in that the reactive gas is selected from the group including oxygen and nitrogen.

6. A dual magnetron sputtering power supply in accordance with any one of the preceding claims in which an inert gas (Ar) is supplied to the vacuum chamber at another cathode or at a central feed point (22) in the vacuum chamber or at any other appropriate point in or adjacent the vacuum chamber.

7. A dual magnetron sputtering power supply in accordance with one of the preceding claims, wherein each said feedback signal (V₁, V₄) is measured between the respective cathode and ground.

8. A dual magnetron sputtering power supply in accordance with one of the preceding claims, wherein each said control circuit (18, 20) is a slow regulator relative to the frequency of the applied feedback signal (V₁, V₄).

9. A dual magnetron sputtering power supply in accordance with claim 1, wherein said further regulators (30, 32) are one of hard regulators and soft regulators.

10. A dual magnetron sputtering power supply in accordance with claim 1, wherein said reactive gas is O₂ and said probes are Lambda sensors (λ₁, λ₄).

11. A dual magnetron sputtering power supply in accordance with any one of the preceding claims, wherein said AC power supply generates AC power in the kHz frequency range, in particular generates AC power in the frequency range 40 to 60 kH, and/or wherein the respective output voltage (V₁, V₄) at each cathode is a rectified AC voltage typically in the range 50 to 400 volts.

12. A dual magnetron sputtering power supply in accordance with any one of the preceding claims in which a regulator is provided for regulating the inert gas supply to maintain the total pressure in the chamber substantially constant irrespective of changes in the partial pressures of the reactive gas supplied to the respective cathodes (1, 4), or in which a regulator is provided for regulating the inert gas supply to maintain the inert gas pressure in the chamber substantially constant, and/or wherein the reactive gas is supplied to each said first and second cathode (1, 4) via a respective gas frame.

13. A dual magnetron sputtering power supply in accordance with any one of the preceding claims, wherein the power dissipated at each of the cathodes (1, 4) is substantially the same over a plurality of cycles of said AC power supply, i.e. over a period of time.

14. A dual magnetron sputtering power supply in accordance with any one of the preceding claims, wherein voltage set point signals (V_{1SET POINT} and V_{4SETPOINT}) are equal to each other at any point in time, and/or wherein said voltage set point signals (V_{1SETPOINT} and V_{4SET POINT}) are variable with respect to time.

15. A magnetron sputtering apparatus in combination with or having a dual magnetron sputtering power supply in accordance with one of the preceding claims.

## Patentansprüche

1. Dual-Magnetron-Sputter-Stromversorgung zur Verwendung mit einer Magnetron-Sputtervorrichtung, die zumindest eine erste und zweite Sputterkathode (1, 4) für den Betrieb im Dual-Magnetron-Sputtermodus aufweist, wobei die Dual-Magnetron-Sputter-Stromversorgung umfasst:
- eine Wechselstromversorgung (8), die mit der ersten und zweiten Sputterkathode (1, 4) verbindbar ist;
- ein erstes und zweites Durchflusssteuerventil (12, 14), die jeweils einer entsprechenden der ersten und zweiten Kathode (1, 4) zugeordnet sind und jeweils ausgebildet sind, um im Gebrauch einen Durchfluss von reaktivem Gas zu der jeweiligen zugehörigen Kathode zu regeln;
- ein Mittel (9, 10), das eingerichtet ist, um im Gebrauch einen Durchfluss von reaktivem Gas zu einer jeden von der ersten und zweiten Kathode (1, 4) über das erste und zweite Durchflusssteuerventil (12, 14) zu leiten;
- für eine jede von der ersten und zweiten Kathode, ein Mittel, das eingerichtet ist, um im Gebrauch ein Spannungsrückführsignal (V₁, V₄), das mit der Spannung in Beziehung steht, die an dieser Kathode (1, 4) vorherrscht, abzuleiten;
- einen Regelkreis (18, 20), der eingerichtet ist, um im Gebrauch den Durchfluss von reaktivem Gas zu der jeweiligen zugehörigen Kathode (1, 4) zu regeln, indem das jeweilige Durchflusssteuerventil (12, 14) geregelt wird, und angepasst ist, um im Gebrauch das jeweilige Durchflusssteuerventil (12, 14) einzustellen, um das Spannungsrückführsignal (V₁, V₄) von der jeweiligen Kathode (1, 4) entsprechend einem Sollpunktwert (V_{1SETPOINT}, V_{4SETPOINT}), der für diese Kathode festgelegt ist, zu erhalten;
**dadurch gekennzeichnet, dass**
der Regelkreis (18, 20) einen entsprechenden Regler für jede Kathode umfasst, der eingerichtet ist, als Eingänge die Spannungsrückführsignale (V₁, V₄) von den Kathoden (1, 4) und jeweilige Sollpunktsignale (V_{1SETPOINT}, V_{4SETPOINT}) zu haben, und eingerichtet ist, um als Ausgänge ein jeweiliges Partialdruck-Sollpunktsignal (P_{1DES}, P4_{DES}) zu erzeugen;
die Dual-Magnetron-Sputter-Stromversorgung ferner eine jeweilige Sonde (λ₁ λ₄) umfasst, die jeweils jeder Kathode (1, 4) zugeordnet und eingerichtet sind, um im Gebrauch ein Istdrucksignal des reaktiven Gases (P_{1ACT}, P_{4ACT}) zu erzeugen; und
weitere Regler (30, 32) eingerichtet sind, so dass im Gebrauch die Partialdruck-Sollpunktsignale (P_{1DES}, P_{4DES}) und die jeweiligen Istdrucksignale (P_{1ACT}, P_{4ACT}) an jeweilige Eingänge der weiteren Regler (30, 32) angelegt werden, wobei die jeweiligen Ausgangssignale davon eingerichtet sind, um im Gebrauch Betätigungssignale (P_{1OUT} und P_{4OUT}) zu erzeugen, die die Durchflusssteuerventile (12, 14) betätigen, die den jeweiligen zugehörigen Kathoden (1, 4) reaktives Gas zuführen.

2. Dual-Magnetron-Sputter-Stromversorgung nach Anspruch 1, wobei das reaktive Gas über das jeweilige Durchflusssteuerventil (12, 14) einer jeden von der ersten und zweiten Kathode (1, 4) über einen Gasrahmen, der jeweils dieser Kathode (1, 4) zugeordnet ist, zugeführt wird.

3. Dual-Magnetron-Sputter-Stromversorgung nach einem der vorhergehenden Ansprüche, wobei das Spannungsrückführsignal (V₁, V₄) für eine jede von der ersten und zweiten Kathode (1, 4) eine von einer Spannungsmessvorrichtung zum Messen der Scheinwechselspannung, die an jede entsprechende Kathode angelegt wird, oder zum Messen einer gleichgerichteten Wechselspannung oder zum Messen einer diesbezüglichen Gleichspannung oder zum Abgreifen der Ausgangsspannung, die durch die Stromversorgung (8) derjeweiligen Kathode (1, 4) zugeführt wird, ist.

4. Dual-Magnetron-Sputter-Stromversorgung nach einem der vorhergehenden Ansprüche, wobei die erste und zweite Kathode (1, 4) entgegengesetzte Kathoden der Magnetron-Sputtervorrichtung sind.

5. Dual-Magnetron-Sputter-Stromversorgung nach einem der vorhergehenden Ansprüche, wobei das Kathodenmaterial einer jeden von der ersten und zweiten Kathode (1, 4) aus der Gruppe ausgewählt ist, die Metalle, wie etwa Aluminium oder Titan, Halbleiter, wie etwa Silizium, und Mischungen aus irgendwelchen der Vorstehenden, umfasst, und dass das reaktive Gas aus der Gruppe ausgewählt ist, die Sauerstoff und Stickstoff umfasst.

6. Dual-Magnetron-Sputter-Stromversorgung nach einem der vorhergehenden Ansprüche, bei welcher ein inertes Gas, (Ar) der Vakuumkammer an einer anderen Kathode oder an einem zentralen Einspeisepunkt (22) in der Vakuumkammer oder an irgendeinem anderen geeigneten Punkt in oder benachbart zu der Vakuumkammer zugeführt wird.

7. Dual-Magnetron-Sputter-Stromversorgung nach einem der vorhergehenden Ansprüche, wobei jedes Rückführsignal (V₁, V₄) zwischen der jeweiligen Kathode und Masse gemessen wird.

8. Dual-Magnetron-Sputter-Stromversorgung nach einem der vorhergehenden Ansprüche, wobei jeder Steuerkreis (18, 20) ein langsamer Regler bezüglich der Frequenz des angelegten Rückführsignals (V₁, V₄) ist.

9. Dual-Magnetron-Sputter-Stromversorgung nach Anspruch 1, wobei die weiteren Regler (30, 32) harte Regler oder weiche Regler sind.

10. Dual-Magnetron-Sputter-Stromversorgung nach Anspruch 1, wobei das reaktive Gas O₂ ist und die Sonden Lambda-Sensoren (λ₁, λ₄) sind.

11. Dual-Magnetron-Sputter-Stromversorgung nach einem der vorhergehenden Ansprüche, wobei die Wechselstromversorgung Wechselstrom im kHz-Frequenzbereich erzeugt, insbesondere Wechselstrom im Frequenzbereich von 40 bis 60 kHz erzeugt, und/oder wobei die jeweilige Ausgangsspannung (V₁, V₄) an jeder Kathode eine gleichgerichtete Wechselspannung ist, die in der Regel im Bereich von 50 bis 400 Volt liegt.

12. Dual-Magnetron-Sputter-Stromversorgung nach einem der vorhergehenden Ansprüche, bei welcher ein Regler zum Regeln der Zufuhr von inertem Gas vorgesehen ist, um den Gesamtdruck in der Kammer ungeachtet von Änderungen in den Partialdrücken des reaktiven Gases, das den jeweiligen Kathoden (1, 4) zugeführt wird, im Wesentlichen konstant zu halten, oder bei welcher ein Regler zum Regeln der Zufuhr von inertem Gas vorgesehen ist, um den Druck des inerten Gases in der Kammer im Wesentlichen konstant zu halten, und/oder wobei das reaktive Gas einer jeden von der ersten und zweiten Kathode (1, 4) über einen jeweiligen Gasrahmen zugeführt wird.

13. Dual-Magnetron-Sputter-Stromversorgung nach einem der vorhergehenden Ansprüche, wobei der Strom, der an jeder der Kathoden (1, 4) dissipiert wird, über eine Mehrzahl von Zyklen der Wechselstromversorgung, d.h. über einen Zeitraum, im Wesentlichen gleich ist.

14. Dual-Magnetron-Sputter-Stromversorgung nach einem der vorhergehenden Ansprüche, wobei die Spannungssollpunktsignale (V_{1SETPOINT} und V_{4SET POINT}) zu jedem Zeitpunkt gleich sind und/oder wobei die Spannungssollpunktsignale (V_{1SETPOINT} und V_{4SETPOINT}) mit Bezug auf die Zeit variabel sind.

15. Magnetron-Sputtervorrichtung in Kombination mit einer Dual-Magnetron-Sputter-Stromversorgung nach einem der vorhergehenden Ansprüche oder die eine solche aufweist.

## Revendications

1. Alimentation de puissance pour projection par double magnétron destinée à être utilisée avec un appareil de projection par magnétron ayant au moins une première et une seconde cathode de projection (1,4) pour fonctionner dans le mode de projection par double magnétron, ladite alimentation de puissance pour projection par double magnétron comprenant :
- une alimentation de puissance en courant alternatif (8) susceptible d'être connectée à la première et à la seconde cathode de projection (1, 4) ;
- une première et une seconde valve de commande d'écoulement (12, 14) associées chacune avec une cathode respective parmi ladite première et ladite seconde cathode (1, 4) et adaptées chacune à commander, en utilisation, un écoulement de gaz réactif vers la cathode respectivement associée ;
- un moyen (9, 10) agencé pour alimenter, en utilisation, un écoulement de gaz réactif vers chacune de ladite première et ladite seconde cathode (1, 4) via ladite première et ladite seconde valve de commande d'écoulement (12, 14) ;
- pour chacune de ladite première et ladite seconde cathode, un moyen agencé pour dériver, en utilisation, un signal de rétroaction de voltage (V₁, V₄) en relation au voltage régnant à ladite cathode (1, 4) ;
- un circuit de commande (18, 20) agencé pour commander, en utilisation, l'écoulement de gaz réactif vers la cathode respectivement associée (1, 4) en commandant la valve de commande d'écoulement respective (12, 14) et adapté à ajuster, en utilisation, la valve de commande d'écoulement respective (12, 14) pour obtenir le signal de rétroaction de voltage (V₁, V₄) depuis la cathode respective (1, 4) correspondant à une valeur de point fixe (V_{1POINT FIXE}, V_{4POINT FIXE}) fixée pour cette cathode ;
**caractérisée en ce que**
ledit circuit de commande (18, 20) comprend un régulateur respectif pour chaque cathode, agencé pour recevoir à titre d'entrée les signaux de rétroaction de voltage (V₁, V₄) depuis les cathodes (1, 4) et les signaux de point fixe respectifs (V_{1POINT FIXE}, V_{4POINT FIXE}), et agencé pour produire à titre de sortie un signal de pression partielle respectif au point fixe (P_{1DES,} P_{4DES}) ;
l'alimentation de puissance pour projection par double magnétron comprend en outre une sonde respective (λ₁, λ₄) respectivement associée avec chaque cathode (1, 4) et agencée pour générer, en utilisation, un signal de pression actuelle du gaz réactif (P_{1ACT}, P_{4ACT}) ;
et
d'autres régulateurs (30, 32) agencés de telle façon que, en utilisation, les signaux de pression partielle au point fixe (P_{1DES}, P_{4DES}) et les signaux de pression actuelle respectifs (P_{1ACT}, P_{4ACT}) sont appliqués à des entrées respectives desdits autres régulateurs (30, 32), dont les signaux de sortie respectifs sont agencés pour générer, en utilisation, des signaux d'actionnement (P_{1OUT} et P_{4OUT}) actionnant les valves de commande d'écoulement (12, 14) alimentant un gaz réactif aux cathodes respectivement associées (1, 4).

2. Alimentation de puissance pour projection par double magnétron selon la revendication 1, dans laquelle le gaz réactif est alimenté via la valve de commande d'écoulement respective (12, 14) à chacune de ladite première et ladite seconde cathode (1, 4) via un groupe à gaz respectivement associé avec cette cathode (1, 4).

3. Alimentation de puissance pour projection par double magnétron selon l'une quelconque des revendications précédentes, dans laquelle le signal de rétroaction de voltage (V_{1,} V₄) pour chacune de ladite première et ladite seconde cathode (1, 4) est un signal venant d'un dispositif de mesure de voltage pour mesurer le voltage en courant alternatif apparent appliqué à chaque cathode respective, ou pour mesurer un voltage en courant alternatif rectifié, ou pour mesurer un voltage en courant continu en relation, ou pour palper le voltage de sortie alimenté par l'alimentation de puissance (8) à la cathode respective (1, 4).

4. Alimentation de puissance pour projection par double magnétron selon l'une quelconque des revendications précédentes, dans laquelle ladite première et ladite seconde cathode (1, 4) sont des cathodes opposées de l'appareil pour projection par magnétron.

5. Alimentation de puissance pour projection par double magnétron selon l'une quelconque des revendications précédentes, dans laquelle le matériau de cathode de chacune de ladite première et ladite seconde cathode (1, 4) est sélectionné parmi le groupe incluant des métaux comme l'aluminium ou le titane, des semi-conducteurs comme du silicium et des mélanges quelconques des matériaux précédents, et en ce que le gaz réactif est sélectionné parmi le groupe incluant l'oxygène et l'azote.

6. Alimentation de puissance pour projection par double magnétron selon l'une quelconque des revendications précédentes, dans laquelle un gaz inerte (Ar) est alimenté à la chambre à vide vers une autre cathode, ou à un point d'alimentation central (22) dans la chambre à vide ou en un quelconque autre point approprié dans ou en position adjacente à la chambre à vide.

7. Alimentation de puissance pour projection par double magnétron selon l'une quelconque des revendications précédentes, dans laquelle chacun desdits signaux de rétroaction (V₁, V₄) est mesuré entre la cathode respective et la terre.

8. Alimentation de puissance pour projection par double magnétron selon l'une quelconque des revendications précédentes, dans laquelle chaque circuit de commande (18, 20) est un régulateur lent en relation avec la fréquence du signal de rétroaction appliquée (V1, V4).

9. Alimentation de puissance pour projection par double magnétron selon la revendication 1, dans laquelle lesdits autres régulateurs (30, 32) sont soit des régulateurs dits "durs" soit des régulateurs dits "souples".

10. Alimentation de puissance pour projection par double magnétron selon la revendication 1, dans laquelle ledit gaz réactif est O₂ et lesdites sondes sont des capteurs lambda (λ₁, λ₄).

11. Alimentation de puissance pour projection par double magnétron selon l'une quelconque des revendications précédentes, dans laquelle ladite alimentation de puissance en courant alternatif génère une puissance en courant alternatif dans la gamme de fréquence des kilohertz, et génère en particulier une puissance en courant alternatif dans la gamme de fréquence de 40 à 60 kilohertz, et/ou dans laquelle le voltage de sortie respectif (V₁, V₄) à chaque cathode est un voltage à courant alternatif rectifié typiquement dans la gamme de 50 à 400 volts.

12. Alimentation de puissance pour projection par double magnétron selon l'une quelconque des revendications précédentes, dans laquelle un régulateur est prévu pour réguler l'alimentation de gaz inerte et maintenir la pression totale dans la chambre sensiblement constante indépendamment des changements des pressions partielles du gaz réactif fourni aux cathodes respectives (1, 4), ou dans laquelle un régulateur est prévu pour réguler l'alimentation de gaz inerte et maintenir la pression de gaz inerte dans la chambre sensiblement constante, et/ou dans laquelle le gaz réactif est alimenté à chacune de ladite première et ladite seconde cathode (1, 4) via un groupe à gaz respectif.

13. Alimentation de puissance pour projection par double magnétron selon l'une quelconque des revendications précédentes, dans laquelle la puissance dissipée à chacune des cathodes (1, 4) est sensiblement la même sur une pluralité de cycles de ladite alimentation de puissance à courant alternatif, c'est-à-dire sur une période temporelle.

14. Alimentation de puissance pour projection par double magnétron selon l'une quelconque des revendications précédentes, dans laquelle les signaux de voltage à point fixe (V_{1POINT FIXE}, V_{4POINT} FIXE) sont égaux l'un à l'autre à un quelconque instant, et/ou dans laquelle lesdits signaux de voltage à point fixe (V_{1POINT FIXE}, V_{4POINT} FIXE) sont variables par rapport au temps.

15. Appareil de projection par magnétron en combinaison avec ou ayant une alimentation de puissance pour projection par double magnétron selon l'une quelconque des revendications précédentes.
